# EUROPEAN PATENT APPLICATION

(11) **EP 4 144 477 A1**
(43) Date of publication of application: **08.03.2023**
(21) Application number: 22192901.1
(22) Date of filing: 30.08.2022
(51) Int. Cl.: B23K 35/26, B23K 35/36, B23K 35/362, H05K 3/34, C22C 13/00, B23K 35/02

(54) **SOLDER COMPOSITION AND METHOD FOR MANUFACTURING ELECTRONIC BOARD**

(30) Priority: 02.09.2021 JP 2021143444; 04.08.2022 JP 2022124745
(71) Applicant: Tamura Corporation, Tokyo 178-8511 (JP)
(72) Inventor: Munekawa, Yurika, Iruma-shi, Saitama (JP); Kizukuri, Rihoko, Iruma-shi, Saitama (JP); Saito, Tadahiro, Iruma-shi, Saitama (JP); Kumakura, Ichiro, Iruma-shi, Saitama (JP)
(74) Representative: Grünecker Patent- und Rechtsanwälte PartG mbB

(57) **Abstract**

A solder composition includes: a flux composition containing a (A) rosin resin, a (B) activator, a (C) thixotropic agent, and a (D) solvent; and (E) solder powder, in which the (B) component contains at least one selected from the group consisting of (B1) dicarboxylic acid and (B2) aromatic carboxylic acid, the (C) component contains at least one selected from the group consisting of a (C1) amide thixotropic agent having a molecular weight of less than 400 or a hydroxyl equivalent of 350 or less and a (C2) glycerol thixotropic agent having a hydroxyl equivalent of 350 or less, and a content of the (A) component is in a range from 30 mass% to 70 mass% with respect to 100 mass% of the flux composition.

## Description

### TECHNICAL FIELD

The present invention relates to a solder composition and a method for manufacturing an electronic board.

### BACKGROUND ART

A solder composition is a paste mixture provided by kneading solder powder and a flux composition (a composition containing, for instance, a rosin resin, activator and solvent) (see Patent Literature 1: JP 5887330 B).

When soldering is performed using the solder composition, a flux residue remains around a joint portion after the soldering. This flux residue contains an activator component and the like. There is a particular concern that due to dew condensation or the like, ion migration may occur by moisture entering the residue distributed across electrodes. In addition, presence of the flux residue on a surface sometimes causes defects in a molding process or a coating process, or poor wire bonding. For this reason, it is desirable to remove this flux residue by washing after the bonding.

For a typical washing, for instance, a detergent whose main component is an organic solvent with high detergency has been used. However, a large amount of the solvent may cause water pollution, fire accidents, air pollution and the like and may affect occupational health, so that regulations have been strengthened.

In recent years, an aqueous detergent whose main component is water with a decreased amount of the solvent used has been used. Accordingly, washability of a flux residue tends to be problematically deteriorated due to a change in components of the detergent.

Meanwhile, printability has been increasingly demanded in order to address highly dense mounting. A flux composition containing a large amount of a thixotropic agent in order to improve printability and prevent sagging during printing tends to cause a flux residue to be less washable. In light of the above, a solder composition exhibiting an excellent washability of a flux residue by an aqueous detergent and an excellent sagging during printing has been demanded.

### SUMMARY OF THE INVENTION

An object of the invention is to provide a solder composition exhibiting an excellent washability of a flux residue by an aqueous detergent and an excellent sagging during printing, and to provide a method for manufacturing an electronic board using the solder composition.

According to an aspect of the invention, there is provided a solder composition including: a flux composition containing a (A) rosin resin, a (B) activator, a (C) thixotropic agent, and a (D) solvent; and (E) solder powder, in which the (B) component contains at least one selected from the group consisting of (B1) dicarboxylic acid and (B2) aromatic carboxylic acid, the (C) component contains at least one selected from the group consisting of a (C1) amide thixotropic agent having a molecular weight of less than 400 or a hydroxyl equivalent of 350 or less and a (C2) glycerol thixotropic agent having a hydroxyl equivalent of 350 or less, and a content of the (A) component is in a range from 30 mass% to 70 mass% with respect to 100 mass% of the flux composition.

According to another aspect of the invention, there is provided a method for manufacturing an electronic board by soldering using the solder composition according to the above aspect of the invention, the method including: applying the solder composition to an electronic board; placing an electronic component on the solder composition; mounting the electronic component on the electronic board through heating by a reflow furnace under predetermined conditions; and washing a flux residue on the electronic board using an aqueous detergent.

According to the above aspects of the invention, a solder composition exhibiting an excellent washability of a flux residue by an aqueous detergent and an excellent sagging during printing, and a method for manufacturing an electronic board using the solder composition can be provided.

### DESCRIPTION OF EMBODIMENT(S)

### Flux Composition

Firstly, a flux composition used in an exemplary embodiment will be described. The flux composition used in the exemplary embodiment, which is a component other than solder powder in a solder composition, includes a (A) rosin resin, a (B) activator, a (C) thixotropic agent, and a (D) solvent described below.

### (A) Component

Examples of the (A) rosin resin used in the exemplary embodiment include rosins and a rosin-modified resin. Examples of the rosins include gum rosin, wood rosin and tall oil rosin. Examples of the rosin-modified resin include disproportionated rosin, polymerized rosin, hydrogenated rosin, and derivatives thereof. Examples of the hydrogenated rosin include fully hydrogenated rosin, partially hydrogenated rosin, and hydrogenated product of unsaturated-organic-acid modified rosin (also referred to as "hydrogenated acid modified rosin"), which is a modified rosin of an unsaturated organic acid such as an aliphatic unsaturated monobasic acid (e.g., (meth)acrylic acid), an aliphatic unsaturated dibasic acid (e.g., α,β-unsaturated carboxylic acid such as fumaric acid and maleic acid), and an unsaturated carboxylic acid having an aromatic ring (e.g., cinnamic acid). One of the above rosin resin may be used alone, or two or more thereof may be used in mixture.

Among the above rosin resin, polymerized rosin, or rosin-modified resin substituted by a hydroxyl group is preferable, and polymerized rosin is particularly preferable in terms of washability of a flux residue by an aqueous detergent.

A content of the (A) component needs to be in a range from 30 mass% to 70 mass% with respect to 100 mass% of the flux composition. At the content of the (A) component of equal to or more than the above lower limit, a copper-foil surface of a soldering land is prevented from being oxidized, so that so-called solderability, which is a property of making molten solder easily get wet on the copper-foil surface, can be improved to sufficiently reduce solder balls. At the content of the (A) component of equal to or less than the above upper limit, the flux residue can be sufficiently washed. From the similar viewpoint, the content of the (A) component is preferably in a range from 40 mass% to 60 mass%, more preferably from 45 mass% to 55 mass%.

### (B) Component

The (B) activator used in the exemplary embodiment needs to include at least one selected from the group consisting of (B1) dicarboxylic acid and (B2) aromatic carboxylic acid.

A well-known dicarboxylic acid can be appropriately selected as the (B1) component. Moreover, in terms of washability of the flux residue and an activation effect, the (B1) component is dicarboxylic acid preferably having 4 to 12 carbon atoms, more preferably dicarboxylic acid having 4 to 5 carbon atoms.

Examples of the (B1) component include oxalic acid, malonic acid, succinic acid, glutaric acid, adipic acid, pimelic acid, suberic acid, azelaic acid, sebacic acid, dodecanedioic acid, and eicosanedioic acid. Among the above examples, in terms of washability of the flux residue and the activation effect, succinic acid, glutaric acid, azelaic acid, sebacic acid, or dodecanedioic acid is preferable, succinic acid or glutaric acid is more preferable, and succinic acid is particularly preferable.

A well-known aromatic carboxylic acid can be appropriately selected as the (B2) component. Moreover, in terms of washability of the flux residue and the activation effect, the (B2) component is preferably aromatic carboxylic acid having a hydroxyl group and an amino group in one molecule, or a heterocycle in one molecule.

Examples of the (B2) component include 2-naphthoic acid, 3-hydroxy-2-naphthoic acid, benzoic acid, anthranilic acid, salicylic acid, and picolinic acid. Among the above examples, in terms of washability of the flux residue and the activation effect, 3-hydroxy-2-naphthoic acid, anthranilic acid, salicylic acid, or picolinic acid is preferable, 3-hydroxy-2-naphthoic acid, salicylic acid, or picolinic acid is more preferable, and 3-hydroxy-2-naphthoic acid or picolinic acid is particularly preferable.

In the exemplary embodiment, in terms of balance between washability of the flux residue and properties such as solderability, the (B1) component and the (B2) component are preferably used in combination, at least one of succinic acid or glutaric acid and at least one of 3-hydroxy-2-naphthoic acid or picolinic acid are more preferably used in combination, and succinic acid, 3-hydroxy-2-naphthoic acid, and picolinic acid are particularly preferably used in combination.

The (B) component may further contain another activator (hereinafter also referred to as a (B3) component) in addition to the (B1) component and the (B2) component as long as an object of the invention is achievable. Examples of the (B3) component include: an organic acid other than the (B1) component and the (B2) component; a halogen activator; and an amine activator. However, from the viewpoint that the (B3) component may adversely affect washability of the flux residue, the (B) component preferably consists of the (B1) component and the (B2) component. A total of the contents of the (B1) component and the (B2) component is preferably 85 mass% or more, more preferably 90 mass% or more, and particularly preferably 95 mass% or more with respect to 100 mass% of the (B) component.

The content of the (B) component is preferably in a range from 3 mass% to 20 mass%, more preferably in a range from 4 mass% to 15 mass%, particularly preferably in a range from 5 mass% to 12 mass% with respect to 100 mass% of the flux composition. The content of the (B) component of equal to or more than the above lower limit tends to improve the activation effect. Meanwhile, the content of the (B) component of equal to or less than the above upper limit tends to be able to maintain an insulating property of the flux composition.

### (C) Component

The (C) thixotropic agent used in the exemplary embodiment needs to contain at least one selected from the group consisting of a (C1) amide thixotropic agent having a molecular weight of less than 400 or a hydroxyl equivalent of 350 or less, and a (C2) glycerol thixotropic agent having a hydroxyl equivalent of 350 or less.

The (C1) component is an amide thixotropic agent. When the amide thixotropic agent has no hydroxyl group and a molecular weight of 400 or more, washability of the flux residue by an aqueous detergent is insufficient. When the amide thixotropic agent has a hydroxyl group and a hydroxyl equivalent of more than 350, washability of the flux residue by an aqueous detergent is insufficient.

Examples of the (C1) component include ethylene bishydroxystearic acid amide (molecular weight: 625, hydroxyl equivalent: 313), hexamethylene hydroxystearic acid amide (molecular weight: 681, hydroxyl equivalent: 341), lauric acid amide (molecular weight: 199), stearic acid amide (molecular weight: 284), hydroxystearic acid amide (molecular weight: 299, hydroxyl equivalent: 299), and ethylene biscapric acid amide (molecular weight: 369). Among the above examples, in terms of sagging during printing, ethylene bishydroxystearic acid amide or hexamethylene hydroxystearic acid amide is preferable and ethylene bishydroxystearic acid amide is particularly preferable.

The (C2) component is a glycerol thixotropic agent having a hydroxyl equivalent of 350 or less. When the glycerol thixotropic agent has a hydroxyl equivalent of more than 350, washability of the flux residue by an aqueous detergent is insufficient.

The (C2) component is exemplified by a hydrogenated castor oil.

The (C) component may further contain another thixotropic agent (hereinafter also referred to as a (C3) component) in addition to the (C1) component and the (C2) component as long as an object of the invention is achievable. Examples of the (C3) component include an amide thixotropic agent other than the (C1) component, a glycerol thixotropic agent other than the (C2) component, kaolin, colloidal silica, organic bentonite, and glass frit. However, from the viewpoint that the (C3) component may adversely affect washability of the flux residue, the (C) component preferably consists of the (C1) component and the (C2) component. A total of the contents of the (C1) component and the (C2) component is preferably 85 mass% or more, more preferably 90 mass% or more, and particularly preferably 95 mass% or more with respect to 100 mass% of the (C) component.

A content of the (C) component is preferably in a range from 3 mass% to 15 mass%, more preferably in a range from 4 mass% to 12 mass%, particularly preferably in a range from 5 mass% to 10 mass% with respect to 100 mass% of the flux composition. At the content of the (C) component of equal to or more than the above lower limit, sagging during printing tends to be further improved. Meanwhile, at the content of the (C) component of equal to or less than the above upper limit, washability of the flux residue tends to be further improved.

### (D) Component

A well-known solvent can be appropriately selected as the (D) solvent used in the exemplary embodiment. The solvent preferably has a boiling point of 170 degrees C or more. A glycol solvent is also preferable.

Examples of the solvent include diethylene glycol, dipropylene glycol, triethylene glycol, hexylene glycol, hexyl diglycol, 1,5-pentanediol, methyl carbitol, butyl carbitol, 2-ethylhexyl diglycol (EHDG), octanediol, phenyl glycol, diethylene glycol monohexyl ether, tetraethylene glycol dimethyl ether, and dibutyl maleic acid. One of these solvents may be used alone, or two or more thereof may be used in mixture.

A content of the (D) component is preferably in a range from 10 mass% to 60 mass%, more preferably in a range from 20 mass% to 50 mass% with respect to 100 mass% of the flux composition. When the content of the (D) component falls within the above range, the obtained solder composition can have a viscosity appropriately adjusted to a suitable range.

### Antioxidant

The flux composition in the exemplary embodiment preferably further contains an antioxidant in terms of solder meltability and the like. A well-known antioxidant is appropriately usable as the antioxidant used herein. Examples of the antioxidant includes a sulfur compound, a hindered phenol compound and a phosphite compound. Among the above examples, a hindered phenol compound is preferable.

Examples of the hindered phenol compound include pentaerythritol tetrakis[3-(3,5-di-tert-butyl-4-hydroxyphenyl)propionate], bis[3-(3-tert-butyl-4-hydroxy-5-methylphenyl)propionic acid][ethylenebis(oxyethylene)], N,N'-bis[2-[2-(3,5-di-tert-butyl-4-hydroxyphenyl)ethylcarbonyloxy]ethyl]oxamide, and N,N'-bis{3-(3,5-di-tert-butyl-4-hydroxyphenyl)propionyl}hydrazine.

### Other Components

The flux composition used in the exemplary embodiment may include another additive and further another resin as required in addition to the (A) component, the (B) component, the (C) component, the (D) component, and the antioxidant. Examples of the another additive include an antifoaming agent, modifier, delustering agent, and foaming agent. A content of the additive is preferably in a range from 0.01 mass% to 5 mass% with respect to 100 mass% of the flux composition. The another resin is exemplified by an acryl resin.

### Solder Composition

Next, the solder composition of the exemplary embodiment will be described. The solder composition of the exemplary embodiment contains the above-described flux composition of the exemplary embodiment and (E) solder powder as described below.

A content of the flux composition is preferably in a range from 5 mass% to 35 mass%, more preferably in a range from 7 mass% to 15 mass%, particularly preferably in a range from 8 mass% to 12 mass% with respect to 100 mass% of the solder composition. At the content of the flux composition of less than 5 mass% (i.e., at a content of the solder powder exceeding 95 mass%), the amount of the flux composition is insufficient as a binder, making the flux composition unlikely to easily mix with the solder powder. Meanwhile, at the content of the flux composition exceeding 35 mass% (i.e., at a content of the solder powder of less than 65 mass%), the resulting solder composition is unlikely to form a desired solder joint.

### (E) Component

The (D) solder powder used in the exemplary embodiment preferably consists of lead-free solder powder, however, may be lead-containing solder powder. A solder alloy in the solder powder preferably contains at least one selected from the group consisting of stannum (Sn), copper (Cu), zinc (Zn), silver (Ag), antimony (Sb), lead (Pb), indium (In), bismuth (Bi), nickel (Ni), cobalt (Co), and germanium (Ge).

The solder alloy in the solder powder is preferably an alloy containing stannum as a main component. The solder alloy more preferably contains stannum, silver and copper. The solder alloy may contain at least one of antimony, bismuth, or nickel as an additive element. The flux composition of the exemplary embodiment, even when containing a solder alloy containing an easily oxidizable additive element such as antimony, bismuth and nickel, can reduce occurrence of voids.

Here, the "lead-free solder powder" means powder of solder metal or alloy to which lead is not added. However, lead as an unavoidable impurity may be contained in the lead-free solder powder. In this case, an amount of the lead is preferably 300 mass ppm or less.

Specific examples of the lead-free solder alloy powder include Sn-Ag-Cu solder powder, Sn-Cu solder powder, Sn-Ag solder powder, Sn-Bi solder powder, Sn-Ag-Bi solder powder, Sn-Ag-Cu-Bi solder powder, Sn-Ag-Cu-Ni solder powder, Sn-Ag-Cu-Bi-Sb solder powder, Sn-Ag-Bi-In solder powder, and Sn-Ag-Cu-Bi-In-Sb solder powder.

An average particle size of the (E) component, which is typically in a range from 1 µm to 40 µm, is more preferably in a range from 1 µm to 35 µm, further more preferably in a range from 2 µm to 35 µm, particularly preferably in a range from 3 µm to 32 µm in view of applicability to an electronic board having narrow pitches between solder pads. The average particle size can be measured with a particle-size measurement device using dynamic light scattering.

### Method for Manufacturing Solder Composition

The solder composition of the exemplary embodiment can be manufactured by containing the above-described flux composition and the above-described (E) solder powder at the above predetermined ratio, followed by mixing with agitation.

### Electronic Board

Next, a method for manufacturing an electronic board in the exemplary embodiment will be described. The electronic board in the exemplary embodiment is manufactured by soldering with the above-described solder composition. According to the method for manufacturing the electronic board in the exemplary embodiment, the electronic board is producible by mounting an electronic component on an electronic board (e.g. printed wiring board) using the solder composition.

The above-described solder composition in the exemplary embodiment exhibits an excellent washability of the flux residue by an aqueous detergent and an excellent sagging during printing. Therefore, after soldering, the flux residue can be easily washed off with an aqueous detergent.

In the method for manufacturing the electronic board according to the exemplary embodiment, firstly, the solder composition is applied on the electronic board using a coating applicator.

Examples of the coating applicator to be used herein include a screen printer, a metal mask printer, a dispenser, and a jet dispenser.

The electronic component can be mounted on the electronic board by a reflow process, in which the electronic component is placed on the solder composition applied by the coating applicator and heated by a reflow furnace under predetermined conditions to mount the electronic component on the printed circuit board.

In the reflow process, the electronic component is placed on the solder composition and heated by the reflow furnace under the predetermined conditions. Through the reflow process, a desired solder bonding can be performed between the electronic component and the printed circuit board. As a result, the electronic component can be mounted on the printed circuit board.

The conditions for the reflow process may be suitably set depending on a melting point of the solder. For instance, a preheating temperature is preferably in a range from 140 degrees C to 200 degrees C, more preferably in a range from 150 degrees C to 160 degrees C. A preheating time is preferably in a range from 60 seconds to 120 seconds. A peak temperature is preferably in a range from 230 degrees C to 270 degrees C, more preferably in a range from 240 degrees C to 255 degrees C. A retention time at a temperature of 220 degrees C or more is preferably in a range from 20 seconds to 60 seconds.

After the reflow process, the flux residue on the electronic board is washed off using an aqueous detergent.

As a washing method, an immersion washing, a jet washing and the like can be adopted.

For instance, in the immersion washing, it is only required to immerse the electronic board into the aqueous detergent. At this time, ultrasonic waves may be applied to the electronic board in the aqueous detergent.

A well-known aqueous detergent for the flux residue is usable as the aqueous detergent. Herein, the aqueous detergent refers to a detergent whose main component is water (i.e., water is 50 mass% or more). Examples of a commercially available aqueous detergent include "VIGON US" manufactured by ZESTRON Japan and "PINE ALPHA ST-180K" manufactured by Arakawa Chemical Industries, Ltd.

A temperature of the aqueous detergent during washing is, for instance, in a range from 30 degrees C to 70 degrees C.

A washing time is, for instance, in a range from 1 minute to 10 minutes.

After washing with the aqueous detergent, the electronic board may be rinsed. Rinsing conditions are not particularly limited but only required to include rinsing about in a range from 0.5 minutes to 5 minutes using water in a range from 20 degrees C to 50 degrees C. Alternatively, rinsing may be conducted twice or more.

The solder composition and the electronic board of the exemplary embodiment are not limited by the above exemplary embodiment and thus may be modified and/or improved as long as an object of the invention is achievable.

For instance, in the above method for manufacturing the electronic board, the printed circuit board and the electronic component are bonded to each other through the reflow process. However, any process is usable for bonding the printed circuit board and the electronic component. For instance, the printed circuit board and the electronic component may be bonded by heating the solder composition using a laser beam (i.e., laser heating process) instead of the reflow process. In this case, any laser beam source can be suitably used depending on a wavelength corresponding to an absorption band of the metal. Examples of the laser beam source include a solid-state laser (e.g., ruby, glass and YAG), a semiconductor laser (e.g., GaAs and InGaAsP), a liquid laser (e.g., pigment), and a gas laser (e.g., He-Ne, Ar, CO₂ and excimer).

### Example(s)

Next, the invention is further described in detail with reference to Examples and Comparatives but the scope of the invention is by no means limited by these Examples and Comparatives. It should be noted that materials used in Examples and Comparatives are as follows.
(A) Component
   Rosin resin A: polymerized rosin, trade name: "China Polymerized Rosin" manufactured by Arakawa Chemical Industries, Ltd.
   Rosin resin B: hydrogenated acid modified rosin, trade name: "PINE CRYSTAL KE-604" manufactured by Arakawa Chemical Industries, Ltd.
   Rosin resin C: fully hydrogenated rosin, trade name: "Foral AX" manufactured by Rika Finetech Co., Ltd.
   Rosin resin D: modified rosin, trade name: "HARITACK FG-90" manufactured by Harima Chemicals Co., Ltd.
(B1) Component
   Dicarboxylic acid A: succinic acid
   Dicarboxylic acid B: glutaric acid
   Dicarboxylic acid C: azelaic acid
   Dicarboxylic acid D: sebacic acid
   Dicarboxylic acid E: dodecanedioic acid
   Dicarboxylic acid F: eicosanedioic acid, trade name: "SL-20" manufactured by Okamura Oil Mill, Ltd.
(B2) Component
   Aromatic carboxylic acid A: 2-naphthoic acid
   Aromatic carboxylic acid B: 3-hydroxy-2-naphthoic acid
   Aromatic carboxylic acid C: benzoic acid
   Aromatic carboxylic acid D: anthranilic acid
   Aromatic carboxylic acid E: salicylic acid
   Aromatic carboxylic acid F: picolinic acid
(B3) Component
   Monocarboxylic acid A: palmitic acid
   Monocarboxylic acid B: dodecanoic acid
(C1) Component
   Amide thixotropic agent A: ethylene bishydroxystearic acid amide (molecular weight: 625, hydroxyl equivalent: 313), trade name "Slipax H" manufactured by Mitsubishi Chemical Corporation
   Amide thixotropic agent B: hexamethylene hydroxystearic acid amide (molecular weight: 681, hydroxyl equivalent: 341), trade name "Slipax ZHH" manufactured by Mitsubishi Chemical Corporation
   Amide thixotropic agent C: lauric acid amide (molecular weight: 199), trade name "Diamid Y" manufactured by Mitsubishi Chemical Corporation
   Amide thixotropic agent D: stearic acid amide (molecular weight: 284)
   Amide thixotropic agent E: hydroxystearic acid amide (molecular weight: 299, hydroxyl equivalent: 299), trade name "Diamid KH" manufactured by Mitsubishi Chemical Corporation
   Amide thixotropic agent F: ethylene biscapric acid amide (molecular weight: 369), trade name "Slipax C-10" manufactured by Mitsubishi Chemical Corporation
(C2) Component
   Glycerol thixotropic agent: castor oil (molecular weight: 939, hydroxyl equivalent: 313), trade name "HIMAKOH" manufactured by KF Trading Co., Ltd.
(C3) Component
   Amide thixotropic agent G: ethylenebis stearic acid amide (molecular weight: 593), trade name "Slipax E" manufactured by Nippon Chemical Trading Co., Ltd.
   Amide thixotropic agent H: methylenebis stearic acid amide (molecular weight: 579), trade name "Bisamide LA" manufactured by Nippon Chemical Trading Co., Ltd.
   Amide thixotropic agent I: higher fatty acid polyamide, trade name "TALEN VA-79" manufactured by KYOEISHA CHEMICAL Co., LTD.
   Polyethylene glycol thixotropic agent: polyethylene glycol (molecular weight: 360 to 440), trade name "Polyethylene Glycol 400" manufactured by FUJIFILM Wako Pure Chemical Corporation.
(D) Component
   Solvent: diethylene glycol mono-2-ethylhexyl ether (2-ethylhexyl diglycol (EHDG), boiling point: 272 degrees C), manufactured by NIPPON NYUKAZAI CO., LTD.
(E) Component
   Solder powder: alloy composition of Sn-3.0Ag-0.5Cu, particle diameter distribution of 20 to 38 µm (corresponding to type 4 of IPC-J-STD-005A), and a solder melting point of 217 to 220 degrees C

### Example 1

A rosin resin A of 50 mass%, dicarboxylic acid A of 1 mass%, aromatic carboxylic acid B of 3 mass%, aromatic carboxylic acid F of 1 mass%, a solvent of 40 mass%, and a thixotropic agent A of 5 mass% were charged into a container and mixed with a planetary mixer to obtain a flux composition.

Subsequently, the obtained flux composition of 11 mass% and solder powder of 89 mass% (100 mass% in total) were charged into the container and mixed with a planetary mixer to prepare a solder composition.

### Examples 2 to 15

Solder compositions were prepared in the same manner as in Example 1 except that the above materials were blended in accordance with the corresponding compositions shown in Table 1.

### Comparatives 1 to 8

Solder compositions were prepared in the same manner as in Example 1 except that the above materials were blended in accordance with the corresponding compositions shown in Table 1.

### Examples 16 to 36

Solder compositions were prepared in the same manner as in Example 1 except that the above materials were blended in accordance with the corresponding compositions shown in Table 2.

### Comparatives 9 and 10

Solder compositions were prepared in the same manner as in Example 1 except that the above materials were blended in accordance with the corresponding compositions shown in Table 2.

### Examples 37 to 41

Solder compositions were prepared in the same manner as in Example 1 except that the above materials were blended in accordance with the corresponding compositions shown in Table 3.

### Evaluation of Solder Compositions

Each of the solder compositions was evaluated by a method below in terms of washability (below a chip, next to the chip), sagging during printing, solder ball, and dewetting. The obtained results are shown in Tables 1 to 3.

### (1) Washability (below a chip, next to the chip)

A solder composition was printed on a board where a chip component can be mounted. A chip component (size: 1.6 mm × 0.8 mm) was mounted on the board. The solder composition was melted by a reflow furnace (manufactured by TAMURA CORPORATION) to perform soldering, so that the board for evaluation was obtained. Reflow conditions were a preheating temperature in a range from 130 to 180 degrees C for about 100 seconds and a temperature equal to or more than 220 degrees C for about 60 seconds in which a peak temperature is 240 degrees C.

Next, the obtained board for evaluation was immersed into a container in which an aqueous detergent ("VIGON US" manufactured by ZESTRON Japan at 20% concentration) and washed while being applied with ultrasonic waves (liquid temperature of 60 degrees C and washing time of 5 minutes). Subsequently, after being drained with an air knife, the board was immersed into a container containing room-temperature pure water and was rinsed for the first time (rinse time: for one to two minutes). Further, the board was immersed into a container containing 45-degree C pure water and was rinsed for the second time (rinse time: for one to two minutes). Subsequently, after being drained with an air knife, the board was dried in a hot air drying oven (oven temperature of 70 degrees C) for 10 minutes.

All the chips were removed from the board for evaluation after being washed with the aqueous detergent. Presence or absence of a flux residue below and next to the chips was observed. A ratio (residual ratio) of the number of the chips below and/or next to which a flux residue was found with respect to a total number of the chips was measured. Based on this residual ratio, washability (below and next to the chips) was evaluated in accordance with criteria below.
A: A residual ratio is less than 10%.
B: A residual ratio is 10% or more and less than 20%.
C: A residual ratio is 20% or more and less than 50%.
D: A residual ratio is 50% or more.

### (2) Sagging during Printing

The solder composition was pattern-printed on a double-sided copper-clad laminate from a 0.1-mm pitch to a 1.2-mm pitch in 0.1-mm increments. Subsequently, after the laminate was left still for 10 minutes in an environment with a temperature of 25 degrees C and a humidity of 50%, the minimum pitches with no sagging of the solder were measured. Based on the average of the minimum pitches, sagging during printing was evaluated in accordance with criteria below.
A: The average of the minimum pitches is less than 0.2 mm.
B: The average of the minimum pitches is 0.2 mm or more and less than 0.4 mm.
C: The average of the minimum pitches is 0.4 mm or more and less than 0.6 mm.
D: The average of the minimum pitches is 0.6 mm or more.

### (3) Solder Ball

A test piece of the solder composition was prepared in accordance with conditions specified in JIS Z 3284 Annex 11. The test piece was subjected to a solder ball test. A solder ball was evaluated in accordance with criteria below in terms of an entire appearance of the tested test piece. The prepared test piece was preheated for 60 seconds using a hot plate at 180 degrees C and then melted in a solder bath at 275 degrees C.
A: One big solder ball is formed without any solder ball around.
B: One big solder ball is formed and solder balls with a diameter of 75 µm or less are formed scattered around the big solder ball.
C: One big solder ball is formed and a large number of small solder balls are arranged in a semi-continuous ring around the big solder ball.
D: Solder is in a state other than the above.

### (4) Dewetting

Dewetting was evaluated by a method in accordance with the dewetting test of JIS Z 3284. Specifically, first, surfaces of the copper plate were washed with 2-propanol. One of the surfaces of the copper plate was polished with abrasive paper while 2-propanol was dropped thereon. Subsequently, dirt on the surface was washed with 2-propanol, and dried sufficiently at room temperature. Using a metal mask, a solder composition was applied to the center of the copper plate to prepare a test plate. Next, the solder composition on the test plate was melted in a solder bath of 255 degrees C. Subsequently, the test plate was lifted from the solder bath while being kept horizontal, and cooled to room temperature. Subsequently, a spread degree of the solder was observed in a state in which flux residues were removed with 2-propanol, and dewetting was evaluated in accordance with criteria below.
A: All parts to which the solder composition has been applied are wet with solder.
B: 70% or more of the parts to which the solder composition has been applied are wet with solder.
C: 50% or more and less than 70% of the parts to which the solder composition has been applied are wet with solder.
D: Less than 50% of the parts to which the solder composition has been applied are wet with solder.

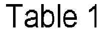

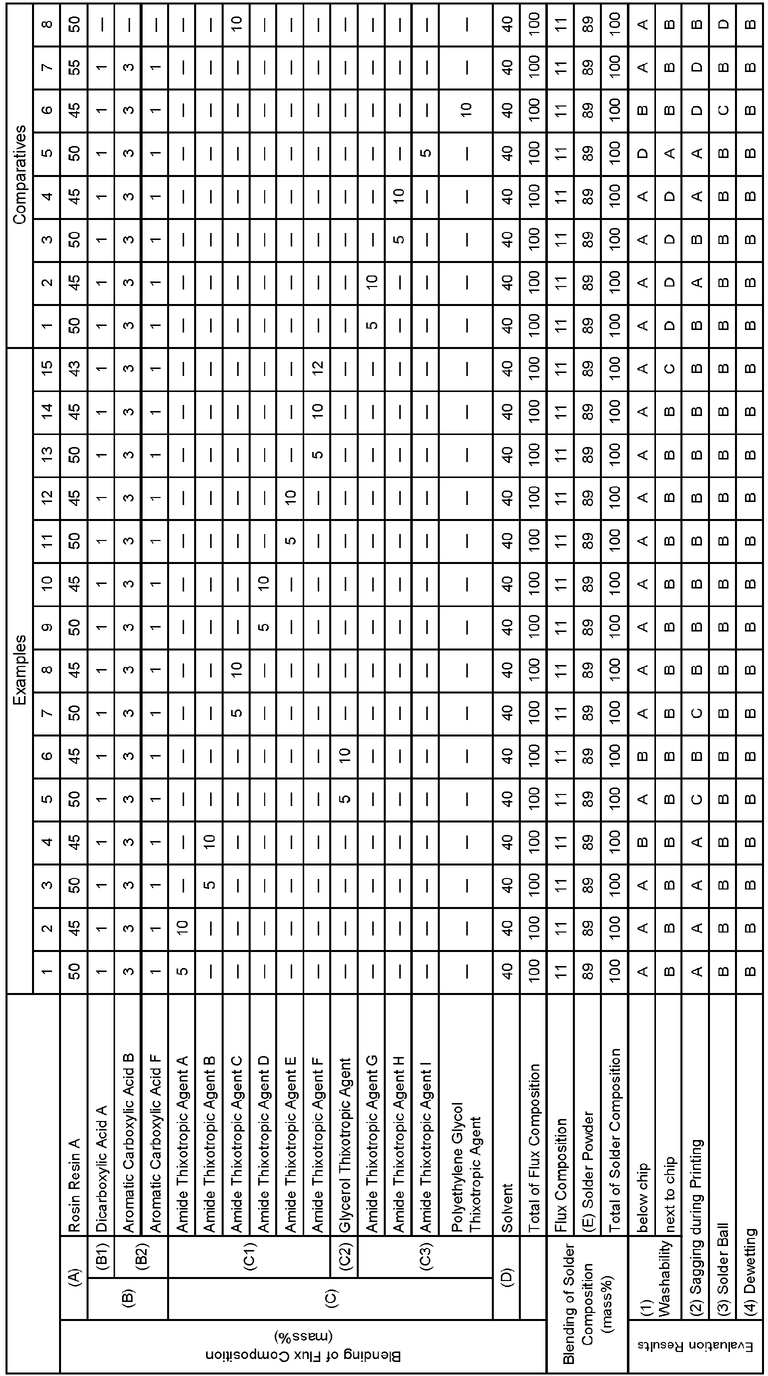

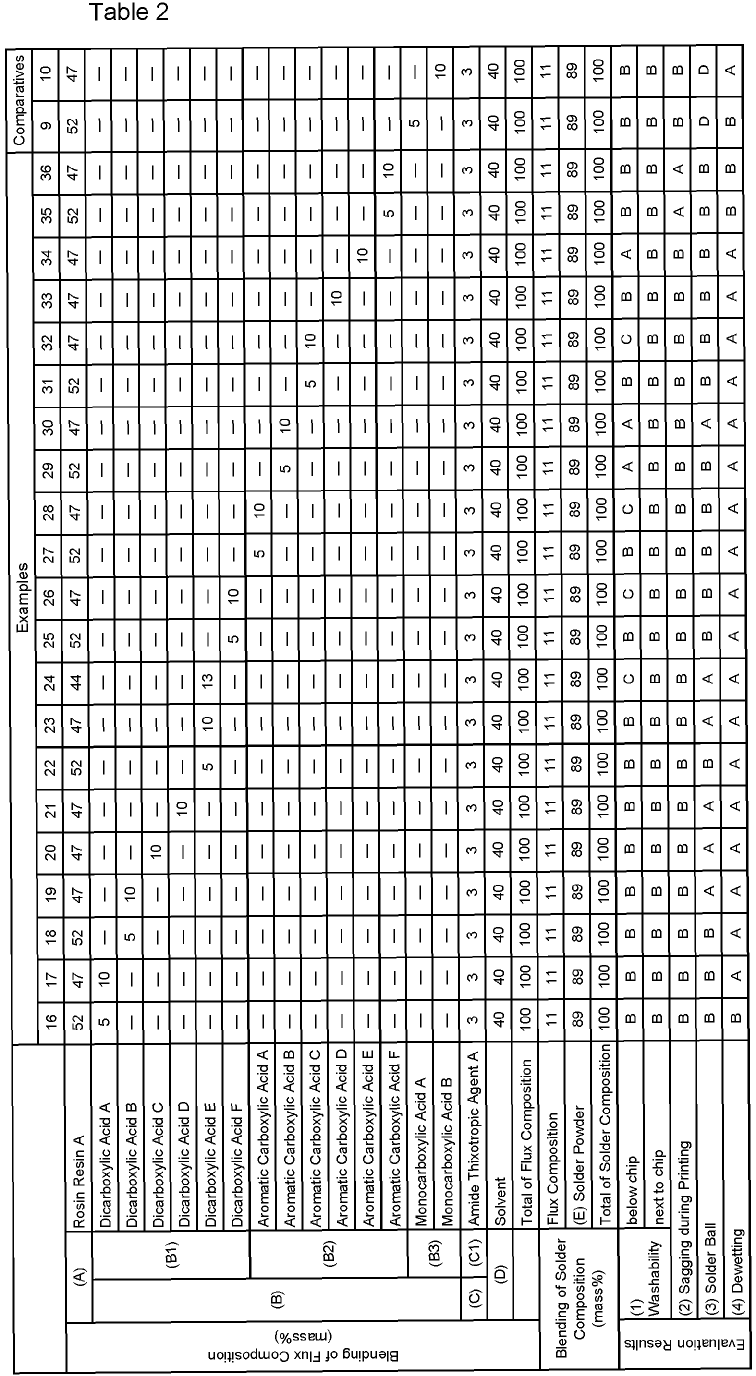

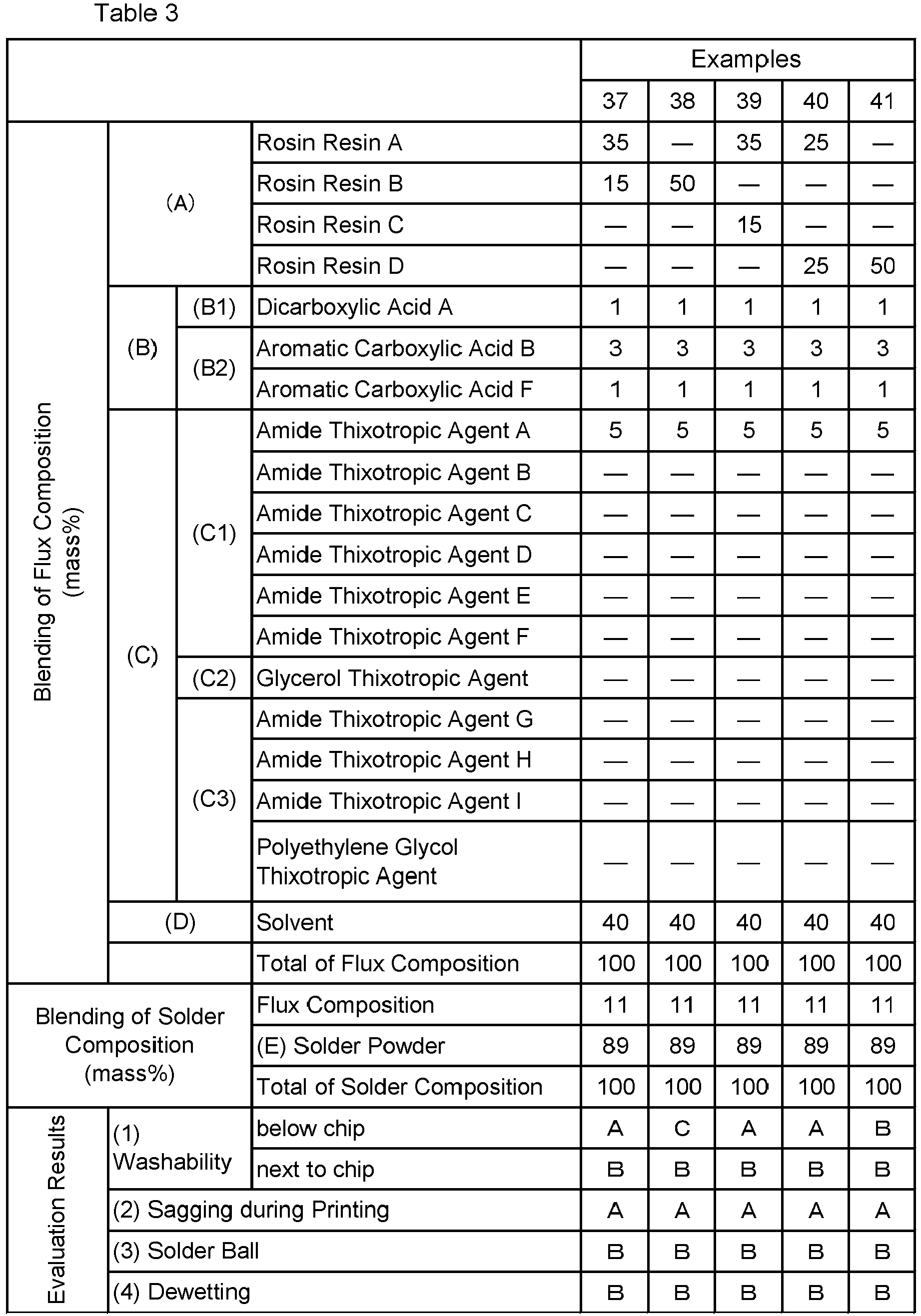

As is clear from results shown in Tables 1, 2, and 3, it has been confirmed that the solder compositions of the invention (Examples 1 to 41) exhibit favorable results in terms of all of washability (under a chip, next to the chip), sagging during printing, solder ball, and dewetting.

It has been thus confirmed that the solder composition of the invention exhibits an excellent washability of a flux residue by an aqueous detergent and an excellent sagging during printing.

It has been also confirmed that substantially the same results of washability evaluation are obtainable even when "PINE ALPHA ST-180K" manufactured by Arakawa Chemical Industries, Ltd. is used as the aqueous detergent in place of "VIGON US" (20% concentration) manufactured by ZESTRON Japan.

## Claims

1. A solder composition comprising:
a flux composition comprising a (A) rosin resin, a (B) activator, a (C) thixotropic agent, and a (D) solvent; and
(E) solder powder, wherein
the (B) component comprises at least one selected from the group consisting of (B1) dicarboxylic acid and (B2) aromatic carboxylic acid,
the (C) component comprises at least one selected from the group consisting of a (C1) amide thixotropic agent having a molecular weight of less than 400 or a hydroxyl equivalent of 350 or less and a (C2) glycerol thixotropic agent having a hydroxyl equivalent of 350 or less, and
a content of the (A) component is in a range from 30 mass% to 70 mass% with respect to 100 mass% of the flux composition.

2. The solder composition according to claim 1, wherein
the (B1) component is dicarboxylic acid having 4 to 12 carbon atoms, and
the (B2) component is aromatic carboxylic acid having a hydroxyl group and an amino group in one molecule or a heterocycle in one molecule.

3. The solder composition according to claim 1 or 2, wherein the (B) component comprises both of the (B1) component and the (B2) component.

4. The solder composition according to any one of claims 1 to 3, wherein the (C1) component is a bisamide thixotropic agent having a hydroxyl group in one molecule.

5. The solder composition according to any one of claims 1 to 4, wherein a content of the (C) component is in a range from 3 mass% to 12 mass% with respect to 100 mass% of the flux composition.

6. The solder composition according to any one of claims 1 to 5, wherein the (A) component comprises polymerized rosin.

7. A method for manufacturing an electronic board by soldering using the solder composition according to any one of claims 1 to 6, the method comprising:
applying the solder composition to an electronic board;
placing an electronic component on the solder composition;
mounting the electronic component on the electronic board through heating by a reflow furnace under predetermined conditions; and
washing a flux residue on the electronic board using an aqueous detergent.
